# EUROPEAN PATENT APPLICATION

(11) **EP 4 546 085 A1**
(43) Date of publication of application: **30.04.2025**
(21) Application number: 24204422.0
(22) Date of filing: 03.10.2024
(51) Int. Cl.: G06F 1/16, H04M 1/02

(54) **DISPLAY DEVICE**

(30) Priority: 24.10.2023 KR 20230142710
(71) Applicant: Samsung Display Co., Ltd., Gyeonggi-do 17113 (KR)
(72) Inventor: RYU, Sim Hee, 17113 Yongin-si (KR); MA, Ki Tae, 17113 Yongin-si (KR); LEE, Kwang Ho, 17113 Yongin-si (KR); LEE, Dong Eun, 17113 Yongin-si (KR)
(74) Representative: Walaski, Jan Filip

(57) **Abstract**

A display device includes a cover window including first and second surfaces, a display panel disposed on the second surface, and a cover panel disposed on the display panel, and including a first surface facing the cover window, and a second surface disposed on an opposite side of the first surface. The first surface of the cover panel and the second surface of the cover window are curved surfaces, and the second surface of the cover panel is a flat surface.

## Description

This application claims priority to Korean Patent Application No. 10-2023-0142710, filed on October 24, 2023.

### BACKGROUND

### 1. Field

The disclosure relates to a display device.

### 2. Description of the Related Art

With the advance of information-oriented society, more and more demands are placed on display devices for displaying images in various ways. The display device may be a flat panel display device such as a liquid crystal display, a field emission display and a light-emitting display. A light-emitting display device may include an organic light-emitting display device including an organic light-emitting diode element as a light-emitting element or a light-emitting diode display device including an inorganic light-emitting diode element such as a light-emitting diode ("LED") as a light-emitting element.

In order to improve aesthetics, flexible display devices in which edge portions of the display device are bent to have a predetermined curvature emerged. To cope with this, research on cover windows including curved surfaces is being actively conducted.

### SUMMARY

Features of the disclosure provide a display device with improved aesthetics.

Features of the disclosure also provide a display device that minimizes cracks in circuit components.

However, features of the disclosure are not restricted to those set forth herein. The above and other features of the disclosure will become more apparent to one of ordinary skill in the art to which the disclosure pertains by referencing the detailed description of the disclosure given below.

In an embodiment of the disclosure, there is provided a display device including, a cover window including a first surface, a display panel disposed on the first surface, and a cover panel disposed on the display panel, and including a second surface facing the cover window, and a third surface disposed on an opposite side of the second surface, wherein the first surface and the second surface are curved, and the third surface is flat.

In an embodiment, the display panel is curved along the first surface.

In an embodiment, a curvature of the first surface and a curvature of the second surface are identical to each other.

In an embodiment, a radius of curvature of the first surface is 100 millimeters (mm) to 200 mm.

In an embodiment, the curvature of the second surface and a curvature of the third surface are identical to each other.

In an embodiment, the cover panel comprises, a buffer layer disposed on the display panel, a bonding layer disposed on the buffer layer, and a support layer disposed on the bonding layer, and comprising a fourth surface facing the cover window, and a fifth surface disposed on an opposite side of the fourth surface, wherein the fourth surface is curved, and the fifth surface is flat.

In an embodiment, the support layer includes at least one of polyethylene terephthalate ("PET"), polyimide ("PI"), polycarbonate ("PC"), polyethylene ("PE"), polypropylene ("PP"), polysulfone ("PSF"), polymethylmethacrylate ("PMMA"), triacetylcellulose ("TAC") or cycloolefin polymer ("COP").

In an embodiment, the buffer layer and the bonding layer are curved along a shape of the fourth surface.

In an embodiment, the cover panel further comprises at least one of a cover spacer and a heat dissipation layer disposed on the fifth surface, and the cover spacer and the heat dissipation layer have a flat shape.

In an embodiment, the heat dissipation layer includes at least one of copper, silver, gold, aluminum, nickel, stainless steel ("SUS"), graphite, or carbon nanotubes.

In an embodiment, an outermost thickness of the cover panel is smaller than a central thickness of the cover panel.

In an embodiment, the display device may comprise a driving board disposed on the third surface, wherein the driving board is flat along the third surface.

In an embodiment, the display device may further comprise a circuit component disposed (e.g., mounted) on the driving board, wherein the circuit component is disposed on a flat surface of the driving board.

In an embodiment of the disclosure, there is provided a display device including, a display panel, an upper module disposed on a first surface of the display panel, a cover window disposed on the upper module, and having a dome shape, a dome-shaped lower module disposed on a second surface of the display panel opposite to the first surface, and including a bottom surface which is flat, and a driving board disposed on the bottom surface of the lower module.

In an embodiment, the driving board is flat along the bottom surface of the lower module.

In an embodiment, the display device may further comprise a circuit component disposed on the driving board, wherein the circuit component is disposed on a flat surface of the driving board.

In an embodiment, the display panel is curved along a shape of the cover window.

In an embodiment, the upper module is curved along a shape of the cover window.

In an embodiment, the upper module comprises, an anti-reflection layer disposed on one surface of the display panel, and an adhesive layer disposed on the anti-reflection layer, wherein the adhesive layer is in direct contact with the cover window.

In an embodiment, the upper module comprises, a support film disposed on the second surface of the display panel, and a cover panel disposed on the support film, wherein the cover panel may have a dome shape and include a bottom surface which is flat.

In accordance with embodiments of the display device according to the disclosure, aesthetics may be improved.

In accordance with embodiments of the display device according to the disclosure, cracks in the circuit components may be minimized.

However, effects in the embodiments of the disclosure are not limited to those exemplified above and various other effects are incorporated herein.

### BRIEF DESCRIPTION OF THE DRAWINGS

The above and other embodiments, advantages and features of the disclosure will become more apparent by describing in detail embodiments thereof with reference to the attached drawings, in which:
FIG. 1 is a perspective view showing an example of a display device;
FIG. 2 is a front view of an example of a display driving module in an unfolded state;
FIG. 3 is a rear view of an example of a display driving module in an unfolded state;
FIG. 4 is a rear view of an example of a display driving module in a bent state;
FIG. 5 is a schematic side view of an example of a display driving module in a bent state along line X1-X1' of FIG. 4;
FIG. 6 is a schematic cross-sectional view illustrating an example of a stacked structure of a display module;
FIG. 7 is a cross-sectional view showing an example of a cover window;
FIG. 8 is a cross-sectional view showing an example of a main body unit;
FIG. 9 is an enlarged view of area A of FIG. 8;
FIG. 10 is an enlarged view of area B of FIG. 8;
FIG. 11 is an exploded perspective view showing an example of a cover panel;
FIG. 12 is a cross-sectional view showing an example of a cover panel;
FIG. 13 is a cross-sectional view showing an example of a main body unit;
FIG. 14 is a cross-sectional view showing an example of a cover panel;
FIG. 15 is an exploded perspective view showing an example of a cover panel;
FIG. 16 is a cross-sectional view showing an example of a main body unit;
FIG. 17 is a cross-sectional view showing an example of a cover panel;
FIG. 18 is a cross-sectional view showing an example of a main body unit; and
FIG. 19 is a cross-sectional view showing an example of a cover panel.

### DETAILED DESCRIPTION

Embodiments of the disclosure will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, embodiments of the disclosure will be described in detail with reference to the accompanying drawings.

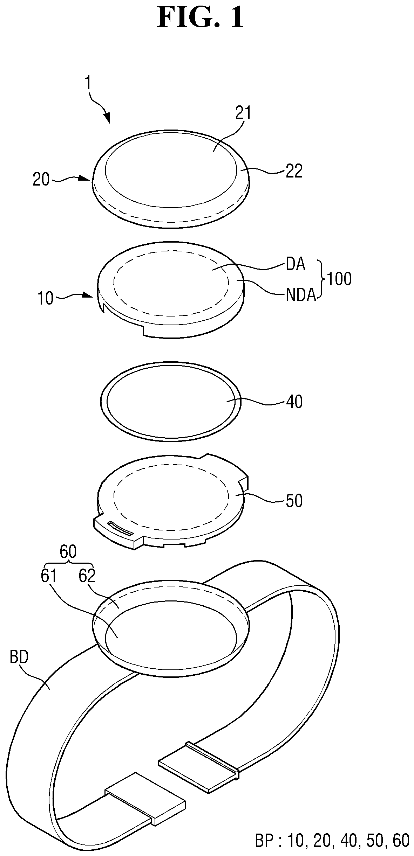

FIG. 1 is a perspective view showing an example of a display device.

Referring to FIG. 1, a display device 1 may include a main body unit BP and a wearable portion BD. Herein, the display device 1 is illustrated as being a smart watch, but is not limited thereto. The display device 1 may be a variety of display devices 1 such as a smartphone, a television, and a computer.

The main body unit BP may include a display driving module 10 on which an image is displayed, a cover window 20, a bonding member 40, a middle frame (or simply frame) 50, and a lower cover 60. The lower cover 60, the middle frame 50, the bonding member 40, the display driving module 10, and the cover window 20 may be sequentially arranged in the main body unit BP.

The display driving module 10 may include a display panel 100. The display panel 100 may be a screen on which various information, content, user interface, or the like are displayed as images. The display panel 100 may be an organic light-emitting display panel, a liquid crystal display panel, or the like, but is not limited thereto. The display panel 100 may include a display area DA where an image is displayed and a non-display area NDA disposed around the display area DA. As shown in FIG. 1, the shape of the display panel 100 may be substantially circular in a plan view, but is not limited thereto and may have various shapes, including an oval or a polygon such as a quadrangle.

The cover window 20 may be disposed on top of the display driving module 10 to protect the display driving module 10. The cover window 20 may transmit light emitted from the display driving module 10. The cover window 20 may include a light-blocking portion to block a part of the light emitted from the display driving module 10.

The cover window 20 may include or consist of a transparent plastic material, a glass material, or a tempered glass material. For example, the cover window 20 may include or consist of any one of sapphire glass and gorilla glass, or may have a stacked structure thereof. In another example, the cover window 20 may include any one of polyethyleneterephthalate ("PET"), polycarbonate ("PC"), polyethersulfone ("PES"), polyethylenapthanate ("PEN"), and polynorbornene ("PNB"). The cover window 20 may include or consist of tempered glass, considering scratch resistance and transparency.

The cover window 20 may be disposed to overlap the display driving module 10 and cover the entirety of the surface of the display driving module 10. The cover window 20 may have a substantially similar shape to the display driving module 10 in a plan view, but its size may be larger than that of the display driving module 10. The cover window 20 may protrude outwardly more than the display driving module 10. The shape of the cover window 20 in a plan view may be the same as the shape of the main body unit BP in a plan view, for example. In an example, the planar shape of the cover window 20 may be substantially a circular shape, but is not limited thereto and may be various shapes, e.g., a polygonal shape such as a quadrilateral shape, or an elliptical shape, for example.

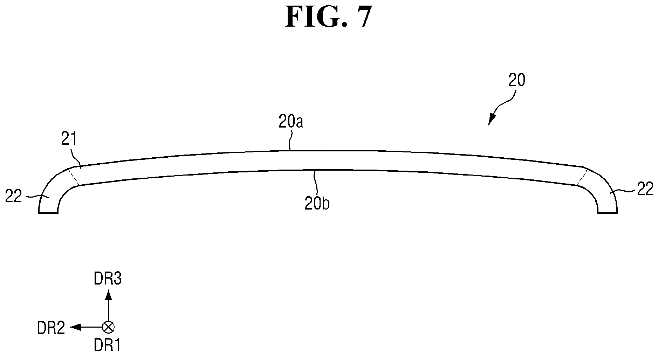

The cover window 20 may have a three-dimensional shape. For example, the cover window 20 may have a dome shape. The cover window 20 may have a shape that protrudes convexly toward a display surface, for example. In another example, the cover window 20 may have a concavely recessed shape on the opposite side of the display surface. The display surface may be a surface (e.g., the top surface in the drawing) disposed in a direction in which light emitted from the display panel 100 passes through the cover window 20 and exits. The shape of the cover window 20 will be described later with reference to FIG. 7.

The cover window 20 may include a central portion 21 and an outer portion 22.

The central portion 21 may be disposed in the center of the cover window 20. The central portion 21 may correspond to the display area DA of the display driving module 10. The central portion 21 of the cover window 20 may cover the entirety of the display area DA of the display driving module 10, but is not limited thereto and may cover only a part of the display area DA of the display driving module 10.

The central portion 21 may include a curved surface. The top and bottom surfaces of the central portion 21 may be curved surfaces, for example. The top surface of the central portion 21 may be a curved surface that protrudes convexly toward the display surface, and the bottom surface of the central portion 21 may be a curved surface that is concavely recessed on the opposite surface of the display surface. The top and bottom surfaces of the central portion 21 may be curved surfaces that are convexly curved toward the display surface.

The outer portion 22 may be disposed around the central portion 21. The outer portion 22 may be disposed to surround the central portion 21. The outer portion 22 may be bent from the central portion 21 and curved. The outer portion 22 may be bent from the edge of the central portion 21.

In an embodiment, the outer portion 22 may include a curved surface with a predetermined curvature. In another example, the outer portion 22 may include a flat surface. In another example, the outer portion 22 may include both flat and curved surfaces having different curvatures.

The curvature of the central portion 21 and the curvature of the outer portion 22 may be constant for each region, but they are not limited thereto and may vary for each region. The central portion 21 and the outer portion 22 may have a curved shape and be inclined at different angles in each region, for example. The central portion 21 and the outer portion 22 may have different curvatures in each region. As the central portion 21 and the outer portion 22 are curved into a curved shape, the cover window 20 may be represented as a three-dimensional window or a three-dimensional sidewall window. The display device 1 illustrated may include the cover window 20 having a three-dimensional shape (e.g., a dome shape) to improve aesthetics.

The bonding member 40 may be disposed between the cover window 20 and the middle frame 50. The bonding member 40 may bond the cover window 20 and the middle frame 50 to each other. The bonding member 40 may be an adhesive tape with an adhesive material applied to opposite sides thereof and having waterproof or dustproof function.

The bonding member 40 may be disposed along the edge of the middle frame 50. The bonding member 40 may have an annular shape with a perforated central portion in a plan view. The bonding member 40 may have a donut shape or a ring shape in a plan view, for example. In plan view, the shape and size of the bonding member 40 may correspond to the shape and size of the middle frame 50. In a plan view, when the middle frame 50 has a circular shape, the bonding member 40 may also have a circular shape, for example.

The middle frame 50 may be disposed between the cover window 20 and the lower cover 60. The middle frame 50 may be an intermediate bonding member for bonding the cover window 20 to the lower cover 60. The middle frame 50 may include a bracket, for example.

The lower cover 60 may be disposed at the lowest end of the main body unit BP. The lower cover 60 may be disposed below the middle frame 50. The lower cover 60 may be a housing bonded to the middle frame 50.

The lower cover 60 may include a central cover portion 61 and a peripheral portion 62.

The central cover portion 61 may be disposed in the center of the lower cover 60. The central cover portion 61 may correspond to the central portion 21 of the cover window 20.

The peripheral portion 62 may be disposed around the central cover portion 61. The peripheral portion 62 may be disposed to surround the central cover portion 61. The peripheral portion 62 may be bent from the central cover portion 61 and curved. The peripheral portion 62 may be bent from the edge of the central cover portion 61. A part of the peripheral portion 62 may include a curved surface with a predetermined curvature, and a remaining part may be flat. The degree (or angle) by which the peripheral portion 62 is bent from the central cover portion 61 may be an obtuse angle, but is not limited thereto and may be a right angle or an acute angle.

The lower cover 60 may be disposed on the outermost rear surface of the display device 1, may include at least one of a plastic material, a metal material, or a glass material, and may include a color coating layer. The lower cover 60 may be flat glass having a transparent, translucent, or opaque color coating layer.

The lower cover 60 may have the same shape as that of the cover window 20 and may include a glass material having a color coating layer. The lower cover 60 may have a structure that is symmetrical to that of the cover window 20 with the middle frame 50 interposed therebetween, and may include a transparent, translucent, or opaque color coating layer, for example.

The wearable portion BD may be a portion for securing the main body unit BP to the user's wrist or the like. For example, it may be any one of a strap, a chain, and a bracelet.

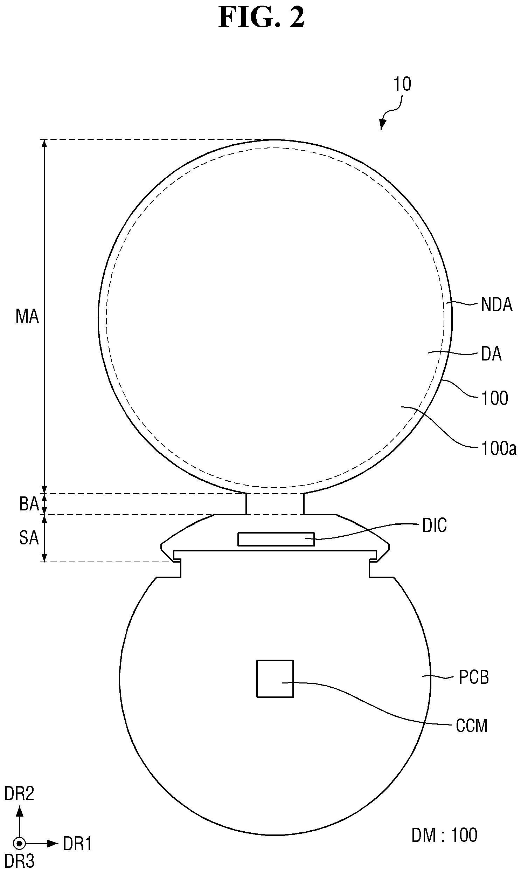

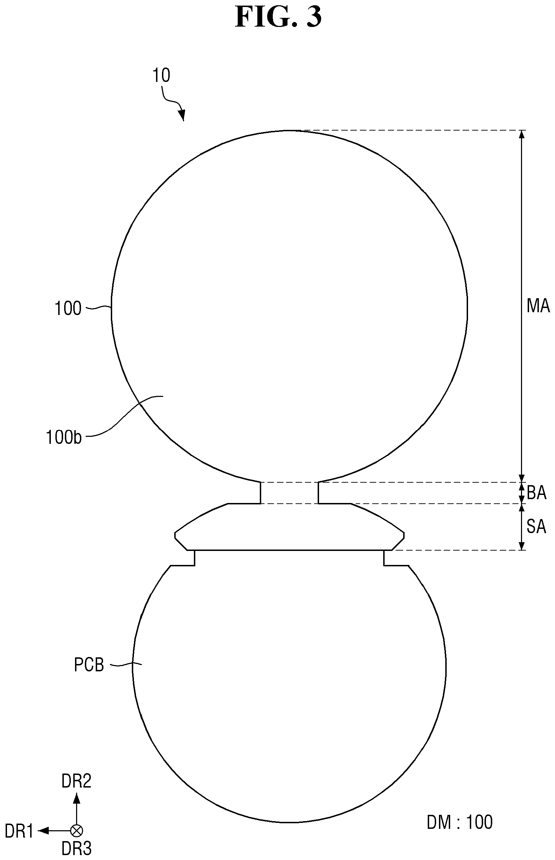

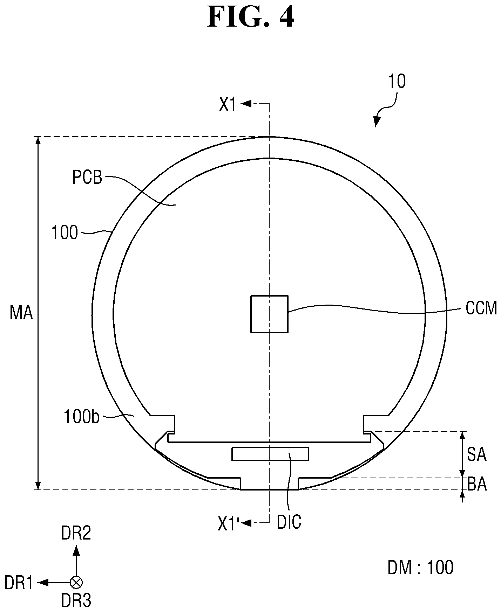

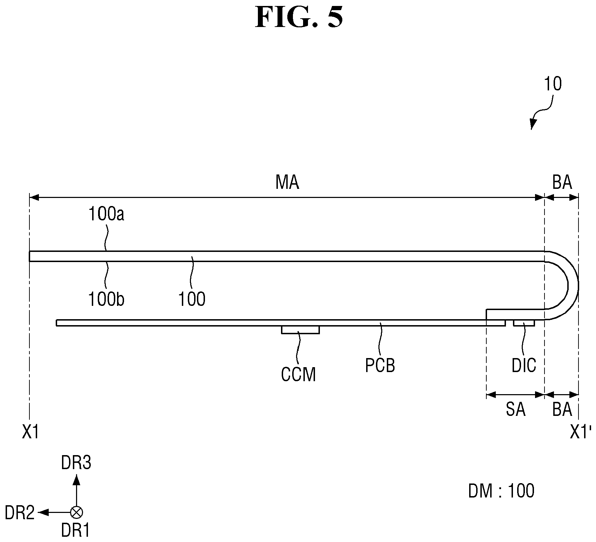

FIG. 2 is a front view of an example of a display driving module in an unfolded state. FIG. 3 is a rear view of an example of a display driving module in an unfolded state. FIG. 4 is a rear view of an example of a display driving module in a bent (folded or closed) state. FIG. 5 is a schematic side view of an example of a display driving module in a bent (folded or closed) state along line X1-X1' of FIG. 4.

FIG. 2 shows a first surface 100a, e.g., the front surface of the display panel 100, and FIGS. 3 and 4 show a second surface 100b, e.g., the rear surface of the display panel 100.

Referring to FIGS. 2 to 5, the display driving module 10 may include a display module DM, a driving chip DIC, a driving board PCB, and circuit components CCM.

The display module DM may include the display panel 100. The display panel 100 may include an organic light-emitting display panel, a micro light-emitting diode ("LED") display panel, a nano LED display panel, a quantum dot light-emitting display panel, a liquid crystal display panel, a plasma display panel, a field emission display panel, an electrophoretic display panel, an electrowetting display panel, or the like. In the following description, the case where an organic light-emitting display panel is applied to the display panel 100 will be exemplified, but the disclosure is not limited thereto, and other types of display panel may be applied.

The display panel 100 may include the display area DA and the non-display area NDA. The display area DA refers to a portion that displays the screen, and the non-display area NDA refers to a portion that does not display the screen.

The display area DA may have a circular shape in a plan view. However, the disclosure is not limited thereto, and the display area DA may have various shapes, such as a rectangle, a rectangle with rounded corners, a square, other polygons, and an oval in a plan view.

The non-display area NDA may be disposed around the display area DA. The non-display area NDA may be a bezel area. The non-display area NDA may surround the display area DA. However, the disclosure is not limited thereto, and for example, the non-display area NDA may not be disposed in at least a part of the surrounding areas of the display area DA.

In the non-display area NDA, signal lines or driving circuits for applying a signal to the display area DA (display area or touch area) may be disposed. In another example, the non-display area NDA may include a part of the touch area, and a sensor member such as a force sensor or the like may be disposed in that region.

The display panel 100 may include a plurality of pixels disposed in the display area DA. The plurality of pixels may be arranged in a matrix. The shape of each pixel may be a rectangular or square shape in a plan view. However, the disclosure is not limited thereto, and it may be a rhombic shape in which each side is inclined with respect to the first direction DR1 or the second direction DR2. Each pixel may include an emission area. Each emission area may be the same as or different from the shape of the pixel. When the shape of the pixel is a rectangular shape, the emission area of the corresponding pixel may have various shapes such as a rectangle, a rhombus, a hexagon, an octagon, and a circle, for example.

In the illustrated figure, the first direction DR1 and the second direction DR2 cross each other as horizontal directions. The first direction DR1 and the second direction DR2 may be orthogonal to each other. In addition, the third direction DR3 crosses the first direction DR1 and the second direction DR2, and may be perpendicular directions orthogonal to each other. In the specification, directions indicated by arrows of the first to third directions DR1, DR2, and DR3 may be also referred to as one side, and the opposite directions thereto may be also referred to as an opposite side.

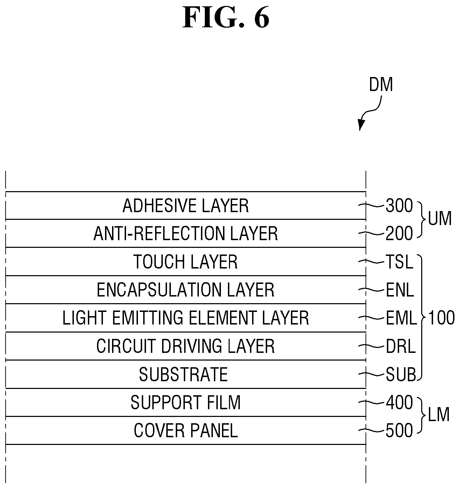

The display driving module 10 may further include a touch member that detects a touch input. The touch member may be provided in the form of a touch layer TSL (refer to FIG. 6) on the display panel 100. In this case, the touch layer TSL (refer to FIG. 6) may be provided integrally with the display panel 100. However, the disclosure is not limited thereto, and the touch member may be provided as a separate panel or film from the display panel 100 and may be attached to the display panel 100. In the following example, a case where the touch member is provided in the form of the touch layer TSL (refer to FIG. 6) is described, but the disclosure is not limited thereto.

The touch area is an area where a touch input is detected. The touch area may overlap the display area DA. In other words, the display area DA may be a region where the screen is displayed and the touch input is detected.

The display panel 100 may include a flexible substrate including or consisting of a flexible polymer material such as polyimide. Accordingly, the display panel 100 may be curved, bent, folded or rolled.

The display panel 100 may include a main region MA, a bending area BA, and a sub-region SA. The bending area BA may be disposed between the main region MA and the sub-region SA in the second direction DR2. The main region MA may be disposed on one side of the bending area BA in the second direction DR2. The sub-region SA may be disposed on an opposite side of the bending area BA in the second direction DR2.

The main region MA may include the display area DA. The display area DA of the display panel 100 may be disposed in the main region MA. In an embodiment, a peripheral edge portion of the display area DA in the main region MA, the entirety of the bending area BA, and the entirety of the sub-region SA may be the non-display area NDA. However, the disclosure is not limited thereto, and the bending area BA and/or the sub-region SA may also include the display area DA.

The shape of the main region MA may correspond to the shape of the cover window 20. When the shape of the cover window 20 is a three-dimensional shape, the shape of the main region MA may also be curved into a three-dimensional shape corresponding to the shape of the cover window 20.

The main region MA may be curved to form a curved surface corresponding to the shape of the cover window 20 or may be bent in a vertical direction. In this case, the display area DA may also be disposed in an edge that is bent together. However, the disclosure is not limited thereto, and the non-display area that does not display a screen may be disposed on the bent edge. In an alternative example, both the display area and the non-display area may be disposed thereon.

The bending area BA may be connected to an opposite side of the main region MA in the second direction DR2. The bending area BA may be connected to the main region MA through a lower short side of the main region MA, for example. The width of the bending area BA, e.g., in the first direction DR1, may be smaller than the width of the main region MA adjacent to the bending area BA, e.g., in the first direction DR1. A connection portion between the main region MA and the bending area BA may have an L-shaped cut portion.

The bending area BA may be an area where the display panel 100 is bent. As shown in FIGS. 4 and 5, the display panel 100 may be bent with a curvature downward in a thickness direction in the bending area BA. The display panel 100 may be bent to an opposite side of the third direction DR3 in the bending area BA, for example.

The bending area BA may have a constant radius of curvature. However, the disclosure is not limited thereto, and the bending area BA may have a different radius of curvature for each section. The surface of the display panel 100 may be reversed as the display panel 100 is bent in the bending area BA. The display panel 100 may be bent in a direction opposite to the first surface 100a, which is the display surface, for example. Accordingly, in the second surface 100b, which is the opposite surface of the display surface, the second surface 100b of the main region MA and the second surface 100b of the sub-region SA may be opposite each other in the third direction DR3.

The sub-region SA may be disposed on an opposite side of the bending area BA in the second direction DR2. The sub-region SA may extend from the bending area BA. The width of the sub-region SA, e.g., in the first direction DR1, may be greater than the width of the bending area BA, e.g., in the first direction DR1. A connection portion between the sub-region SA and the bending area BA may have an L-shaped cut portion.

The size of the sub-region SA may be smaller than the size of the main region MA of the display panel 100. As shown in FIG. 4, when the display panel 100 is in a bent state, the sub-region SA may completely overlap the main region MA. When the display panel 100 is in a bent state, the outer edge of the sub-region SA may be surrounded by the outer edge of the main region MA in a plan view. The outer edge of the sub-region SA may be disposed more inward than the outer edge of the main region MA in a plan view.

As shown in FIG. 5, when the display panel 100 is in a bent state, the sub-region SA may overlap the main region MA in the thickness direction of the display panel 100, i.e., in the third direction DR3. The sub-region SA may be disposed below the main region MA in the third direction DR3.

The driving chip DIC may be disposed on the sub-region SA of the display panel 100. The driving chip DIC may be disposed on the first surface 100a of the display panel 100 in the sub-region SA of the display panel 100. The driving chip DIC may be directly disposed (e.g., mounted) on the display panel 100 using a chip on glass ("COG") or chip on plastic ("COP") method, as shown in the drawing. In another example, the driving chip DIC may be disposed (e.g., mounted) on a flexible film using a chip on film ("COF") method.

The driving chip DIC may generate and output data voltages, power voltages, scan timing signals, or the like. The driving chip DIC may include an integrated circuit for driving the display panel 100. The integrated circuit may include a display integrated circuit and/or a touch unit integrated circuit. However, the disclosure is not limited thereto, and the display integrated circuit and the touch unit integrated circuit may be provided as separate chips or may be provided as one integrated chip.

The driving board PCB may be disposed on one end of the sub-region SA of the display panel 100. A pad portion may be disposed at one end of the sub-region SA of the display panel 100. The pad portion may include a plurality of display signal wiring pads and touch signal wiring pads. The driving board PCB may be connected to the pad portion at one end of the sub-region SA of the display panel 100. The driving board PCB may be attached to the pad portion by a conductive adhesive member such as an anisotropic conductive film and an anisotropic conductive adhesive. The driving board PCB may be a flexible printed circuit board or a flexible film such as a chip on film.

When the display panel 100 is in a bent state, the driving chip DIC and the driving board PCB may be disposed on the opposite side of the main region MA of the display panel 100, with the sub-region SA of the display panel 100 interposed therebetween. That is, the driving chip DIC and the driving board PCB may be disposed on the first surface 100a of the sub-region SA, and as the display panel 100 is bent, they may be disposed away from the main region MA in the third direction DR3.

The size of the driving board PCB may be smaller than the size of the main region MA of the display panel 100. As shown in FIG. 4, when the display panel 100 is in a bent state, the driving board PCB may completely overlap the main region MA of the display panel 100, for example. When the display panel 100 is in a bent state, the outer edge of the driving board PCB may be surrounded by the outer edge of the main region MA of the display panel 100 in a plan view. The outer edge of the driving board PCB may be disposed more inward than the outer edge of the main region MA of the display panel 100 in a plan view.

The shape of the driving board PCB in a plan view may be substantially similar to the shape of the display panel 100 in a plan view. When the display panel 100 has a circular shape in a plan view, at least a part of the driving board PCB may be circular, for example. However, the disclosure is not limited thereto, and the shape of the driving board PCB may be modified in various ways.

The circuit components CCM may be disposed (e.g., mounted) on the driving board PCB. As shown in FIG. 5, when the display panel 100 is in a bent state, the circuit components CCM may be disposed on a side away from the main region MA of the display panel 100 with the driving board PCB interposed therebetween. However, the disclosure is not limited thereto, and when the display panel 100 is in a bent state, some of the circuit components CCM may be disposed on a side close to the main region MA of the display panel 100 with the driving board PCB interposed therebetween.

The circuit components CCM may include various components disposed (e.g., mounted) on the driving board PCB. The circuit components CCM may include various processor chips for controlling the operation of the display device 1. The processor chips may include a touch driving circuit (touch drive integrated circuit ("IC")), a main processor, an application processor ("AP"), a central processing unit ("CPU"), a system chip, or the like.

In the drawing, it is illustrated that the circuit components CCM are disposed in the approximate center of the driving board PCB and the shape of the circuit components CCM is a quadrangle, but the disclosure is not limited thereto. The location and shape of the circuit components CCM may vary depending on the type of component.

FIG. 6 is a schematic cross-sectional view illustrating a stacked structure of a display module.

Referring to FIG. 6, the display module DM may include the display panel 100, an upper module UM disposed on the top of the display panel 100, and a lower module LM disposed below the display panel 100. The upper portion of the display panel 100 may be in a direction in which the display surface faces, and the lower portion of the display panel 100 may be in a direction opposite to the direction in which the display surface faces.

The display panel 100 may include a substrate SUB, a circuit driving layer DRL, a light-emitting element layer EML, an encapsulation layer ENL, and the touch layer TSL.

The substrate SUB may support components disposed thereon. The substrate SUB may include a transparent material. The substrate SUB may include a transparent insulating material such as glass, quartz, or the like, for example. The substrate SUB may be a rigid substrate. However, it is not limited thereto, and may include plastic such as polyimide or the like, and may have a flexible property such that it may be twisted, bent, folded, or rolled.

The circuit driving layer DRL may be disposed on the top surface of the substrate SUB. The circuit driving layer DRL may include a circuit that drives the light-emitting element layer EML of the pixel. The circuit driving layer DRL may include a plurality of thin film transistors.

The light-emitting element layer EML may be disposed on the circuit driving layer DRL. The light-emitting element layer EML may include an organic light-emitting layer, but is not limited thereto. The light-emitting element layer EML may emit light with various luminance levels according to a driving signal transmitted from the circuit driving layer DRL.

The encapsulation layer ENL may be disposed on the light-emitting element layer EML. The encapsulation layer ENL may include an inorganic layer or a laminated layer of an inorganic layer and an organic layer. In another example, the encapsulation layer ENL may include glass or an encapsulation film.

The touch layer TSL may be disposed on the encapsulation layer ENL. The touch layer TSL is a layer for recognizing a touch input, and may function as a touch member. The touch layer TSL may include a plurality of sensing areas and sensing electrodes.

The upper module UM may include an anti-reflection layer 200 and an adhesive layer 300.

The anti-reflection layer 200 may be disposed on the display panel 100. The anti-reflection layer 200 may serve to reduce reflection of external light. The anti-reflection layer 200 may be attached in the form of a polarizing film. In this case, the anti-reflection layer 200 may polarize light passing therethrough. However, the disclosure is not limited thereto, and the anti-reflection layer 200 may be stacked in the form of a color filter layer. In this case, the anti-reflection layer 200 may include a color filter or the like for selectively transmitting light of a predetermined wavelength.

The adhesive layer 300 may be disposed on the anti-reflection layer 200. The adhesive layer 300 may bond the cover window 20 described above to the display panel 100 or the anti-reflection layer 200. The adhesive layer 300 may be an optically clear adhesive ("OCA") film or a pressure sensitive adhesive ("PSA") film. In the drawing, the adhesive layer 300 is shown as being included in the display module DM, but is not limited thereto. The adhesive layer 300 may not be included in the display module DM, but may be attached to the cover window 20 and provided together with the cover window 20, for example.

The lower module LM may include a support film 400 and a cover panel 500.

The support film 400 may be disposed on the bottom surface of the display panel 100. The support film 400 may be disposed between the display panel 100 and the cover panel 500. The support film 400 may support the display panel 100.

The support film 400 may include polyethylene terephthalate ("PET"), polyimide ("PI"), polycarbonate ("PC"), polyethylene ("PE"), polypropylene ("PP"), polysulfone ("PSF"), polymethylmethacrylate ("PMMA"), triacetylcellulose ("TAC"), cycloolefin polymer ("COP"), or the like.

The support film 400 may in some cases be omitted, but is not limited thereto.

The cover panel 500 may be disposed on the support film 400. The cover panel 500 may be disposed below the support film 400. The cover panel 500 may include at least one functional layer to perform a heat dissipation function, an electromagnetic wave shielding function, a buffering function, a strength reinforcement function, a support function, an adhesive function, and/or the like.

The functional layer of the cover panel 500 may be a sheet layer including or consisting of a sheet, a film layer including or consisting of a film, a thin film layer, a coating layer, a panel, a plate, or the like, for example. One functional layer may consist of a single layer or a stack of multiple thin films or coating layers. The functional layer may be a supporting member, a heat dissipation layer, an electromagnetic shielding layer, an impact absorbing layer, a bonding layer, or the like, for example.

FIG. 7 is a cross-sectional view showing an example of a cover window.

Referring to FIG. 7, the cover window 20 may have a dome shape. The cover window 20 may have a shape that protrudes convexly toward a display surface. In another example, the cover window 20 may have a concavely recessed shape on the opposite side of the display surface.

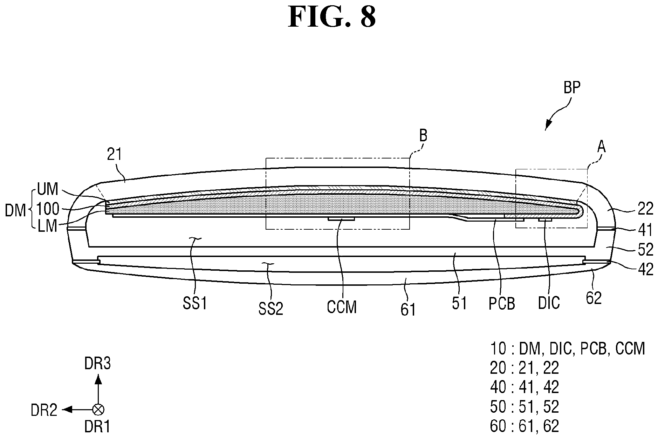

The cover window 20 may include a first surface 20a and a second surface 20b. The first surface 20a may be a surface in the first to third directions DR1, DR2, and DR3, and the second surface 20b may be a surface in the opposite direction of the first to third directions DR1, DR2, and DR3. The second surface 20b may be a surface disposed adjacent to the display driving module 10 (refer to FIG. 8), and the first surface 20a may be a surface disposed on the opposite side of the display driving module 10 (refer to FIG. 8), for example. The first surface 20a may be an outer surface of the cover window 20, and the second surface 20b may be an inner surface of the cover window 20.

The first surface 20a and the second surface 20b of the cover window 20 may be curved surfaces with a predetermined curvature. The first surface 20a and the second surface 20b may be curved surfaces that are convex in the first to third directions DR1, DR2, and DR3, for example.

The curvature of the first surface 20a may vary for each region. The curvature of the second surface 20b may vary for each region. However, the disclosure is not limited thereto, and the first surface 20a may have a constant curvature in all regions, and the second surface 20b may have a constant curvature in all regions. The curvature of the first surface 20a and the curvature of the second surface 20b may be the same as each other, but they are not limited thereto. The curvature of the first surface 20a and the curvature of the second surface 20b may be different from each other.

The radius of curvature of the second surface 20b of the cover window 20 may be approximately 100 millimeters (mm) to approximately 200 mm. Preferably, the radius of curvature of the second surface 20b of the cover window 20 may be approximately 120 mm to approximately 160 mm. When the radius of curvature of the second surface 20b varies for each region, the radius of curvature may be measured with respect to a point having the minimum radius of curvature.

The cover window 20 may include the central portion 21 and the outer portion 22.

The central portion 21 may be disposed in the center of the cover window 20. The outer portion 22 may be disposed around the central portion 21. The outer portion 22 may be disposed to surround the central portion 21. The outer portion 22 may be bent from the central portion 21 and curved. The outer portion 22 may be bent from the edge of the central portion 21.

The curvature of the first surface 20a in the central portion 21 may be smaller than the curvature of the first surface 20a in the outer portion 22, and the curvature of the second surface 20b in the central portion 21 may be smaller than the curvature of the second surface 20b in the outer portion 22. The first and second surfaces 20a and 20b in the central portion 21 may be curved more gently than those in the outer portion 22, and the first and second surfaces 20a and 20b in the outer portion 22 may be curved more sharply than those in the central portion 21. Accordingly, the outer portion 22 may be bent in a direction opposite to the third direction DR3 from the central portion 21.

The curvature of the central portion 21 and the curvature of the outer portion 22 may each be constant for each region, but they are not limited thereto and may vary for each region. The central portion 21 and the outer portion 22 may each have a curved shape and may be inclined at different angles in each region. The central portion 21 and the outer portion 22 may have different curvatures in each region. As the central portion 21 and the outer portion 22 are curved into a curved shape, the cover window 20 may be represented as a three-dimensional window or a three-dimensional sidewall window. The display device 1 in the illustrated example may include the cover window 20 having a three-dimensional shape (e.g., dome shape) to improve aesthetics.

FIG. 8 is a cross-sectional view showing a main body unit.

Referring to FIG. 8, the main body unit BP, as described with reference to FIG. 1, may include the display driving module 10, the cover window 20, the bonding member 40, the middle frame 50, and the lower cover 60.

As described with reference to FIG. 2 or the like, the display driving module 10 may include the display module DM, the driving chip DIC, the driving board PCB, and the circuit components CCM. As described with reference to FIG. 6, the display module DM may include the display panel 100, the upper module UM, and the lower module LM.

The display module DM, the driving chip DIC, the driving board PCB, and the circuit components CCM of the display driving module 10, and the display panel 100, the upper module UM, and the lower module LM of the display module DM have been described above, so detailed description will be omitted.

The cover window 20 may be attached to the display driving module 10 through the upper module UM of the display module DM. The central portion 21 of the cover window 20 may be in direct contact with the upper module UM. The outer portion 22 of the cover window 20 may surround the display driving module 10 in the horizontal direction defined by the first and second directions DR1 and DR2.

The bonding member 40 may include a first bonding member 41 and a second bonding member 42. The bonding member 40 may be an adhesive tape with an adhesive material applied to opposite sides thereof and having waterproof or dustproof function. The first bonding member 41 and the second bonding member 42 may include the same material, but are not limited thereto.

The first bonding member 41 may be disposed on the top surface of the middle frame 50. The first bonding member 41 may be disposed between the middle frame 50 and the cover window 20 in the third direction DR3. The first bonding member 41 may bond the top surface of a middle sidewall 52 of the middle frame 50 to the bottom surface of the outer portion 22 of the cover window 20, for example.

The second bonding member 42 may be disposed on the bottom surface of the middle frame 50. The second bonding member 42 may be disposed between the middle frame 50 and the lower cover 60 in the third direction DR3. The second bonding member 42 may bond the bottom surface of the middle sidewall 52 of the middle frame 50 to the top surface of the peripheral portion 62 of the lower cover 60.

The middle frame 50 may serve as a bracket for fixing the cover window 20 to the lower cover 60.

The display driving module 10 may be disposed between the middle frame 50 and the cover window 20. The top surface of the middle frame 50 may face the bottom surface of the display driving module 10. The top surface of the middle frame 50 may be spaced apart from the bottom surface of the display driving module 10. A first storage space SS1 may be defined between the top surface of the middle frame 50 and the bottom surface of the display driving module 10. The first storage space SS1 may define a space for storing peripheral circuits of an electronic device, such as a host driving system, a memory, and a battery.

The middle frame 50 may include a middle plate 51 and the middle sidewall 52.

The middle plate 51 may be disposed below the display driving module 10. At least one opening through which a cable or the like for electrical connection between the host driving system and a display driving circuit portion connected to the display driving module 10 passes, at least one recess in which various electronic circuit components disposed (e.g., mounted) on the electronic device are arranged, and the like may be disposed in the first storage space SS1 defined between the top surface of the middle plate 51 and the bottom surface of the display driving module 10.

The middle sidewall 52 may be disposed on the side surface of the middle plate 51. The extension direction of the middle sidewall 52 may be different from the extension direction of the middle plate 51. The middle sidewall 52 may support the outer portion 22 of the cover window 20. The middle sidewall 52 may be bonded to the outer portion 22 of the cover window 20 through the first bonding member 41, for example. As a result, the waterproof performance of the display device 1 may be improved and the permeation of foreign substances or the like may be prevented.

The lower cover 60 may be disposed below the middle frame 50. The top surface of the lower cover 60 may face the bottom surface of the middle frame 50, for example. At least a part of the top surface of the lower cover 60 may be spaced apart from at least a part of the bottom surface of the middle frame 50. A second storage space SS2 may be defined between at least a part of the top surface of the lower cover 60 and at least a part of the bottom surface of the middle frame 50. The second storage space SS2 may define a space for storing peripheral circuits of the electronic device that are not placed in the first storage space SS1.

The lower cover 60 may include the central cover portion 61 and the peripheral portion 62.

The central cover portion 61 may be disposed below the middle plate 51. Peripheral circuits of the electronic device that are not placed in the first storage space SS1 may be disposed in the second storage space SS2 defined between the top surface of the central cover portion 61 and the bottom surface of the middle plate 51. A battery or the like for operating the display device 1 may be disposed in the second storage space SS2.

The peripheral portion 62 may be disposed on the side surface of the central cover portion 61. The extension direction of the peripheral portion 62 may be different from the extension direction of the central cover portion 61. The peripheral portion 62 may be supported by the middle sidewall 52. The peripheral portion 62 may be bonded to the middle sidewall 52 through the second bonding member 42. As a result, the waterproof performance of the display device 1 may be improved and the permeation of foreign substances or the like may be prevented.

The lower cover 60 may be detachably bonded to the middle sidewall 52. Tthe second bonding member 42 may be omitted between the middle sidewall 52 and the peripheral portion 62, and a mechanical coupling may be adopted, for example. In this case, battery replacement may be facilitated in the event of battery discharge during use of the display device 1, and disassembly for repair of the display device 1 may be facilitated.

In the display device 1 in the illustrated example, the shape of the top surface of the display module DM may correspond to the shape of the bottom surface of the cover window 20. The top surface of the display module DM may be curved at the same curvature as that of the bottom surface of the cover window 20, for example.

In the display device 1 in the illustrated example, the shape of the bottom surface of the display module DM may be flat. The bottom surface of the lower module LM may be flat, for example. Accordingly, the driving board PCB disposed on the bottom surface of the display module DM (or the bottom surface of the lower module LM) may be attached to a flat surface, thereby preventing the risk of cracking the driving board PCB and the circuit components CCM disposed (e.g., mounted) on the driving board PCB.

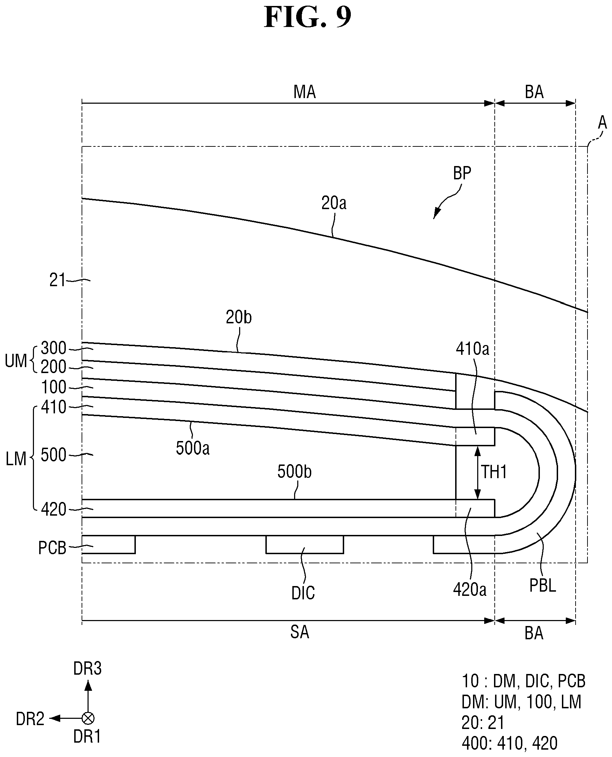

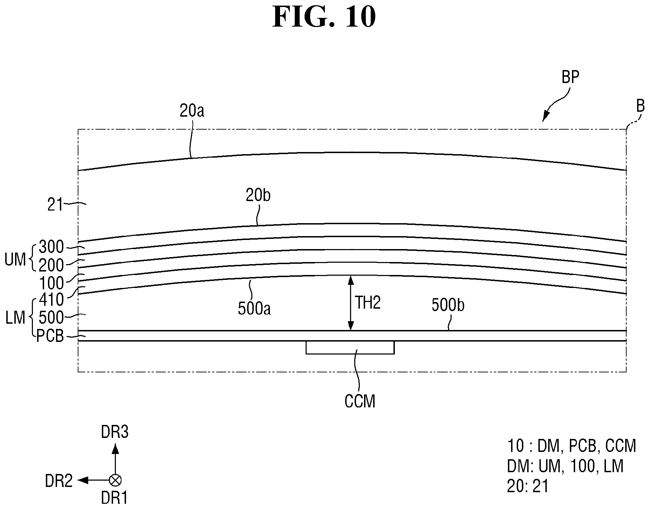

FIG. 9 is an enlarged view of area A of FIG. 8. FIG. 10 is an enlarged view of area B of FIG. 8.

Referring to FIGS. 9 and 10, the display driving module 10 may include the display module DM, the driving chip DIC, the driving board PCB, and the circuit components CCM. The display module DM may include the display panel 100, the upper module UM, and the lower module LM.

The display module DM may further include a bending protection layer PBL. The bending protection layer PBL may be disposed on a partial area of the display panel 100. The bending protection layer PBL may be disposed on the bending area of the display panel 100. However, the disclosure is not limited thereto, and the bending protection layer PBL may also be disposed on areas other than the bending area BA. As shown in the drawing, the bending protection layer PBL may also be disposed in the sub-region SA. In another example, the bending protection layer PBL may also be disposed in the main region MA.

The bending protection layer PBL may include or consist of a polymer compound such as polyimide, acrylate, epoxy, or the like. The bending protection layer PBL may minimize the occurrence of cracks caused by stress applied to the display panel 100 during bending of the display panel 100, and may block the propagation of the cracks. Accordingly, durability of the display module DM may be improved.

The support film 400 may include a first support film 410 and a second support film 420 that are spaced apart from each other. The first support film 410 may be disposed in the main region MA, and the second support film 420 may be disposed in the sub-region SA, for example. The first support film 410 and the second support film 420 may be opposite each other in the third direction DR3 when the display panel 100 is in a bent state. The first support film 410 and the second support film 420 may overlap each other in the third direction DR3 when the display panel 100 is in a bent state.

The cover window 20 may be attached to the display driving module 10 through the adhesive layer 300. The central portion 21 of the cover window 20 may be in direct contact with the adhesive layer 300.

In the display device 1 in the illustrated example, the shape of the upper module UM, at least a part of the display panel 100, and at least a part of the first support film 410 may correspond to the shape of the cover window 20. The upper module UM, at least a part of the display panel 100, and at least a part of the first support film 410 may be curved at the same curvature as that of the second surface 20b of the cover window 20. The upper module UM, at least a part of the display panel 100, and at least a part of the first support film 410 may have a dome shape.

The upper module UM, the display panel 100, and the first support film 410 may have a flat shape before being bonded to the cover window 20. The upper module UM, the display panel 100, and the first support film 410 may have flexible characteristics, so that they may be curved to conform to the shape of the cover window 20 after being bonded to the cover window 20.

The display panel 100 may be curved at the same curvature as that of the cover window 20 in an area in contact with the upper module UM. The first support film 410 may be curved at the same curvature as that of the cover window 20 in an area overlapping the upper module UM in the third direction DR3.

The first support film 410 and the second support film 420 may include flat portions 410a and 420a, respectively. Each of the flat portions 410a and 420a of the first and second support films 410 and 420 may protrude in the first direction DR1 and the second direction DR2 beyond one end of the upper module UM. A part of the display panel 100 disposed on each of the flat portions 410a and 420a of the first and second support films 410 and 420 may have a flat shape. Accordingly, the display panel 100 may be prevented from being bent from a curved portion of the display panel 100 formed by overlapping the upper module UM. This may make it easy to control the shape of the display panel 100 in the bending area BA, and may minimize the repulsive force against the bending protection layer PBL.

In the display device 1 illustrated, the cover panel 500 may include a first surface 500a and a second surface 500b. The first surface 500a of the cover panel 500 may be a surface close to the cover window 20. The second surface 500b of the cover panel 500 may be a surface away from the cover window 20. The first surface 500a of the cover panel 500 may be the top surface, and the second surface 500b of the cover panel 500 may be the bottom surface.

The shape of the first surface 500a of the cover panel 500 may correspond to the shape of the cover window 20. The first surface 500a of the cover panel 500 may have the same curvature as that of the second surface 20b of the cover window 20. For example, the first surface 500a of the cover panel 500 may have a dome shape.

The second surface 500b of the cover panel 500 is a flat surface. The top and bottom surfaces of the second support film 420, the bottom surface of the lower module LM, and the bottom surface of the display module DM may be flat. Accordingly, the driving board PCB disposed on the bottom surface of the display module DM may be attached to a flat surface, thereby preventing the risk of cracks in the driving board PCB and the circuit components CCM disposed (e.g., mounted) on the driving board PCB.

An outermost thickness TH1 of the cover panel 500 may be smaller than a central thickness TH2 of the cover panel 500. Since the center of the first surface 500a of the cover panel 500 is convex toward the cover window 20, and the second surface 500b of the cover panel 500 is flat, the outermost thickness TH1 of the cover panel 500 may be smaller than the central thickness TH2 of the cover panel 500.

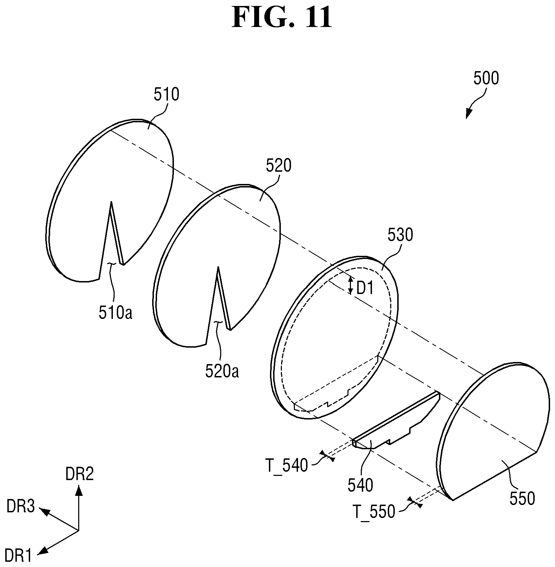

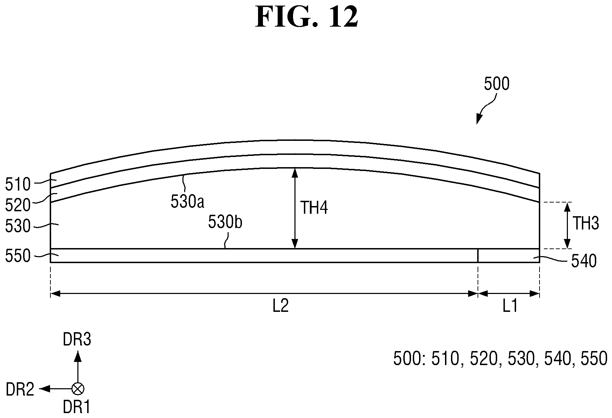

FIG. 11 is an exploded perspective view showing an example of a cover panel. FIG. 12 is a cross-sectional view showing an example of a cover panel.

In the exploded view of FIG. 11, the components of the cover panel 500 are disassembled and the three-dimensional shape is unfolded into a planar shape.

Referring to FIGS. 11 and 12 in addition to FIGS. 8 to 10, the cover panel 500 may include a buffer layer 510, a bonding layer 520, a support layer 530, a cover spacer 540, and a heat dissipation layer 550.

The buffer layer 510 may be disposed on the first support film 410 or the display panel 100. The buffer layer 510 may be disposed below the first support film 410, e.g., in a direction opposite to the third direction DR3, for example. The buffer layer 510 may be disposed on the upper portion of the cover panel 500 and may contact the first support film 410 or the display panel 100.

The buffer layer 510 may absorb external impacts to prevent the display device 1 from being damaged. The buffer layer 510 may be formed as a single layer or a plurality of stacked layers.

The buffer layer 510 may include a material capable of elastic transformation. The buffer layer 510 may include thermoplastic elastomer, polystyrene, polyolefin, polyurethane thermoplastic elastomer, polyamide, synthetic rubber, polydimethylsiloxane, polybutadiene, polyisobutylene, poly(styrene-butadienestyrene), polyurethane, polychloroprene, polyethylene, silicone, or the like, or any combinations thereof, for example.

The buffer layer 510 may include an adhesive layer, a tackifying layer, or a resin layer for bonding with the first support film 410 or the display panel 100. The buffer layer 510, as an adhesive layer, a tackifying layer, or a resin layer, may include the same material as that of the bonding layer 520 to be described later.

Before attaching the cover panel 500 to the support film 400 or the display panel 100, an embossed shape may be formed on the top surface of the buffer layer 510. When an embossed shape is formed on the top surface of the buffer layer 510, the embossed shape of the surface may act as an air passage when attaching the cover panel 500, thereby reducing air bubbles. Once the cover panel 500 is fully attached, the embossed shape on the top surface of the buffer layer 510 may disappear.

The bonding layer 520 may be disposed on the buffer layer 510. The bonding layer 520 may be disposed below the buffer layer 510, e.g., in a direction opposite to the third direction DR3, for example. The bonding layer 520 may be disposed between the buffer layer 510 and the support layer 530. The bonding layer 520 may bond the buffer layer 510 to the support layer 530.

The bonding layer 520 may include an adhesive layer, a tackifying layer, or a resin layer. The bonding layer 520 may include or consist of a polymer material classified into a silicone polymer, a urethane polymer, an SU polymer having a silicone-urethane hybrid structure, an acrylic polymer, an isocyanate polymer, a PVA polymer, a gelatin polymer, a vinyl polymer, a latex polymer, a polyesther polymer, a water-based polyester polymer, or the like, for example. The bonding layer 520 may include a pressure sensitive adhesive ("PSA"), but is not limited thereto.

The support layer 530 may be disposed on the bonding layer 520. The support layer 530 may be disposed below the bonding layer 520, e.g., in a direction opposite to the third direction DR3, for example. The support layer 530 may be disposed between the cover spacer 540 and the bonding layer 520, and between the heat dissipation layer 550 and the bonding layer 520.

The support layer 530 may support the buffer layer 510 and the bonding layer 520. The support layer 530 may maintain the shape of the cover spacer 540 and perform a strength reinforcement function. The support layer 530 may be a strength reinforcement member for reinforcing the display device 1 against external impacts.

The support layer 530 may include at least one of PET, PI, PC, PE, PP, PSF, PMMA, TAC or COP.

The cover spacer 540 may be disposed on the support layer 530. The cover spacer 540 may be disposed below the support layer 530, e.g., in a direction opposite to the third direction DR3.

The cover spacer 540, together with the support layer 530, may prevent the display driving module 10 from being bent due to an external force, or may mitigate the extent to which it is bent. The cover spacer 540 may maintain the display driving module 10 in a relatively flat state even when an external force is applied.

The cover spacer 540 may include a rigid or semi-rigid material. Specifically, the cover spacer 540 may include a metal material such as stainless steel (steel use stainless ("SUS")) and aluminum, or a polymer material such as PMMA, PC, polyvinyl alcohol ("PVA"), acrylonitirle-butadiene-styrene ("ABS"), PET, or the like.

The heat dissipation layer 550 may be disposed on the support layer 530. The heat dissipation layer 550 may be disposed below the support layer 530, e.g., in a direction opposite to the third direction DR3.

The heat dissipation layer 550 may dissipate heat generated in the display device 1 or on the driving board PCB and may shield electromagnetic waves. The heat dissipation layer 550 may include or consist of a conductive metal selected from the group including metals, such as copper, silver, gold, aluminum, nickel, and SUS, having excellent thermal conductivity and combinations thereof. The heat dissipation layer 550 may include graphite and/or carbon nanotubes.

The cover spacer 540 and the heat dissipation layer 550 may be disposed in the same layer. The cover spacer 540 and the heat dissipation layer 550 may be disposed between the support layer 530 and the second support film 420 or between the support layer 530 and the driving board PCB in the third direction DR3, for example. In FIG. 12, the side surfaces of the cover spacer 540 and the heat dissipation layer 550 are shown as being in direct contact with each other, but the disclosure is not limited thereto. The cover spacer 540 and the heat dissipation layer 550 may be spaced apart from each other in the second direction DR2.

The cover spacer 540 and the heat dissipation layer 550 may be disposed side by side in the second direction DR2. The cover spacer 540 may be disposed closer to the bending area BA than the heat dissipation layer 550. In an embodiment, a thickness T_540 of the cover spacer 540 in the third direction DR3 may be the same as a thickness T_550 of the heat dissipation layer 550 in the third direction DR3.

As shown in FIG. 11, the shape of the cover spacer 540 and the heat dissipation layer 550 in a plan view may substantially correspond to the shape of the support layer 530 in a plan view. The size of the cover spacer 540 and the heat dissipation layer 550 may be smaller than the size of the support layer 530 in a plan view. The outer edge of the cover spacer 540 and the heat dissipation layer 550 may be disposed more inward by a first distance D1 than the outer edge of the support layer 530.

The cover spacer 540 and the heat dissipation layer 550 may offset a height difference formed between the sub-region SA of the display panel 100 and the cover panel 500 and between the driving board PCB and the cover panel 500. The cover spacer 540 and the heat dissipation layer 550 may be disposed between the sub-region SA of the display panel 100 and the cover panel 500 and between the driving board PCB and the cover panel 500 in the third direction DR3, so that the display panel 100 and the driving board PCB may be maintained in a flat state, for example. The sub-region SA of the display panel 100 and the driving board PCB may be attached to the lower portion of the cover spacer 540 or the lower portion of the second support film 420 through an adhesive member. Accordingly, the sub-region SA of the display panel 100 and the driving board PCB may be maintained in a fixed state.

In the display device 1 illustrated, the support layer 530 may include a first surface 530a and a second surface 530b. The first surface 530a of the support layer 530 may be a surface close to the cover window 20. The second surface 530b of the support layer 530 may be a surface away from the cover window 20. The first surface 530a of the support layer 530 may be the top surface, and the second surface 530b of the support layer 530 may be the bottom surface.

The shape of the first surface 530a of the support layer 530 may correspond to the shape of the cover window 20. The first surface 530a of the support layer 530 may have the same curvature as that of the second surface 20b of the cover window 20,. The first surface 530a of the support layer 530 may have a dome shape.

The second surface 530b of the support layer 530 may be a flat surface. The top and bottom surfaces of the cover spacer 540 and the heat dissipation layer 550 may be flat. Accordingly, the driving board PCB disposed on the bottom surface of the display module DM may be attached to a flat surface, thereby preventing the risk of cracks in the driving board PCB and the circuit components CCM disposed (e.g., mounted) on the driving board PCB.

The shape of the buffer layer 510 and the bonding layer 520 may correspond to the shape of the first surface 530a of the support layer 530. The shape of the buffer layer 510 and the bonding layer 520 may be curved at the same curvature as that of the first surface 530a of the support layer 530.

The buffer layer 510 and the bonding layer 520 may have a flat shape before being bonded to the support layer 530. The buffer layer 510 and the bonding layer 520 may have flexible characteristics, so that they may be curved to conform to the shape of the first surface 530a of the support layer 530 after being bonded to the support layer 530.

In the drawing, the buffer layer 510 and the bonding layer 520 may define empty spaces 510a and 520a, respectively, in a plan view. As described above, since the first surface 530a of the support layer 530 is a curved surface, the shapes of the buffer layer 510 and the bonding layer 520 may also be curved. When such a curved surface is developed in a plan view, the buffer layer 510 and the bonding layer 520 may define empty spaces 510a and 520a, respectively, in a plan view.

The outermost thickness TH3 of the support layer 530 may be smaller than a central thickness TH4 of the support layer 530. Since the center of the first surface 530a of the support layer 530 is convex toward the cover window 20 and the second surface 530b of the support layer 530 is flat, the outermost thickness TH3 of the support layer 530 may be smaller than the central thickness TH4 of the support layer 530.

Hereinafter, other embodiments of the display device will be described. In the following embodiments, description of the same components as those of the above-described embodiment, which are denoted by like reference numerals, will be omitted or simplified, and differences will be mainly described.

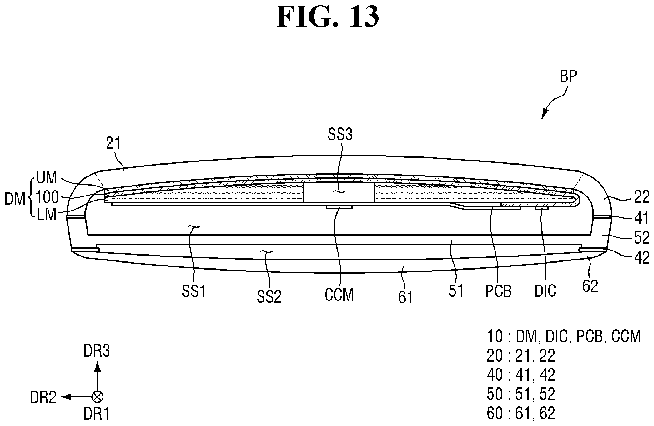

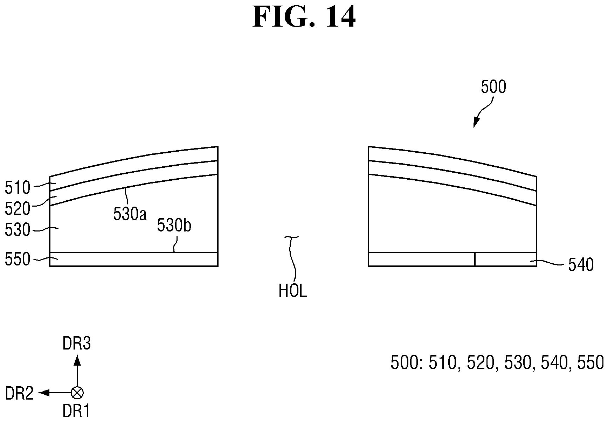

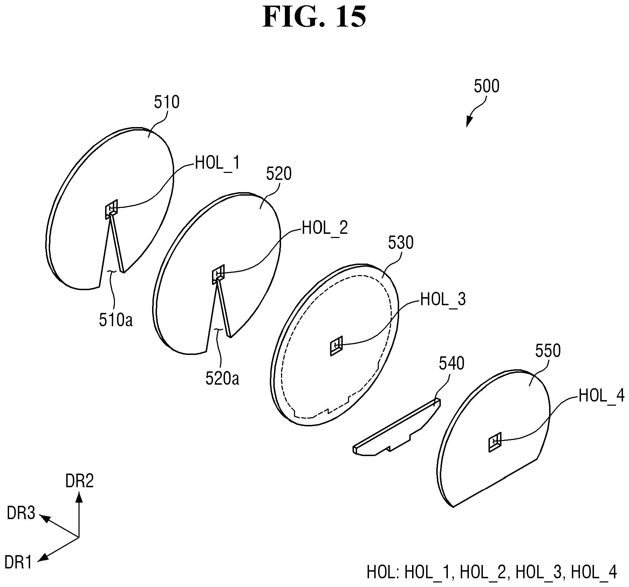

FIG. 13 is a cross-sectional view showing an example of a main body unit. FIG. 14 is a cross-sectional view showing an example of a cover panel. FIG. 15 is an exploded perspective view showing an example of a cover panel.

Referring to FIGS. 13 to 15, the display device 1 illustrated differs from the display device 1 described with reference to FIG. 8, in that it further defines a third storage space SS3 in the shape of a through hole.

More specifically, the display device 1 illustrated defines a third storage space SS3. The third storage space SS3 may be defined between the display panel 100 and the driving board PCB in the third direction DR3. The third storage space SS3 may be a space for storing electronic devices such as an ambient light sensor ("ALS") and a fingerprint sensor on display ("FOD").

The third storage space SS3 may be a hole HOL penetrating the lower module LM. As shown in FIGS. 14 and 15, the third storage space SS3 may be defined as the hole HOL penetrating the cover panel 500.

The hole HOL penetrating the cover panel 500 may penetrate the buffer layer 510, the bonding layer 520, the support layer 530, and the heat dissipation layer 550. Although not shown in the drawing, the hole HOL may penetrate the cover spacer 540 depending on its location.

The hole HOL may include a first hole HOL_1 penetrating the buffer layer 510, a second hole HOL_2 penetrating the bonding layer 520, a third hole HOL_3 penetrating the support layer 530, and a fourth hole HOL_4 penetrating the heat dissipation layer 550.

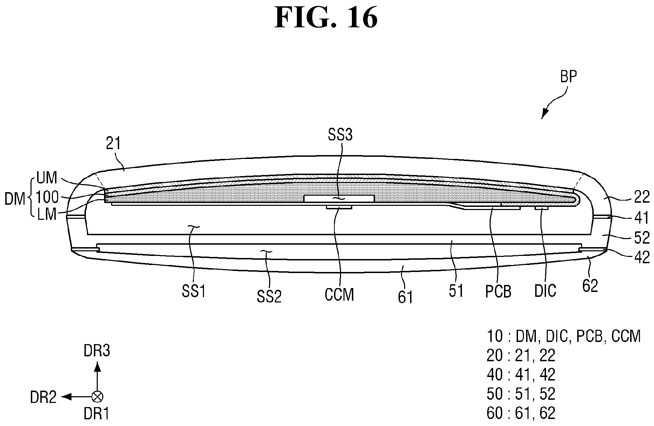

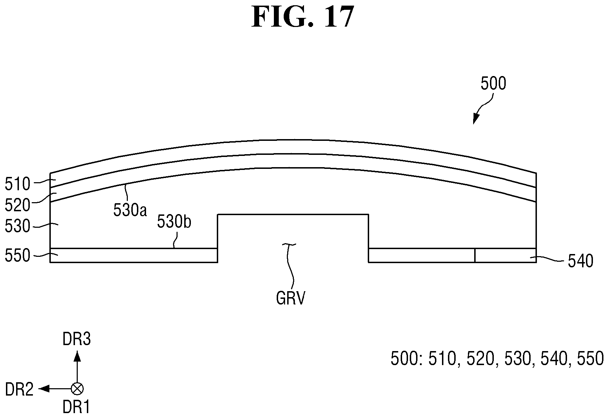

FIG. 16 is a cross-sectional view showing an example of a main body unit. FIG. 17 is a cross-sectional view showing an example of a cover panel.

Referring to FIGS. 16 and 17, the display device 1 illustrated differs from the display device 1 in the examples described above with reference to FIGS. 8 and 13, in that it further defines a third storage space SS3 in the shape of a groove defined adjacent to the driving board PCB.

More specifically, the third storage space SS3 may be a groove GRV defined by recessing at least a part of the bottom surface of the lower module LM. As shown in FIG. 17, the third storage space SS3 may be defined as the groove GRV defined by recessing at least a part of the bottom surface of the cover panel 500 toward the top surface of the cover panel 500.

The groove GRV may penetrate the heat dissipation layer 550 and at least a part of the support layer 530. Although not shown in the drawing, the groove GRV may penetrate the cover spacer 540 depending on its location.

As shown in the drawing, the top surface of the groove GRV may be defined at a predetermined point inside the support layer 530 in the third direction DR3. However, the disclosure is not limited thereto, and the top surface of the groove GRV may be defined at any point inside the buffer layer 510 or the bonding layer 520.

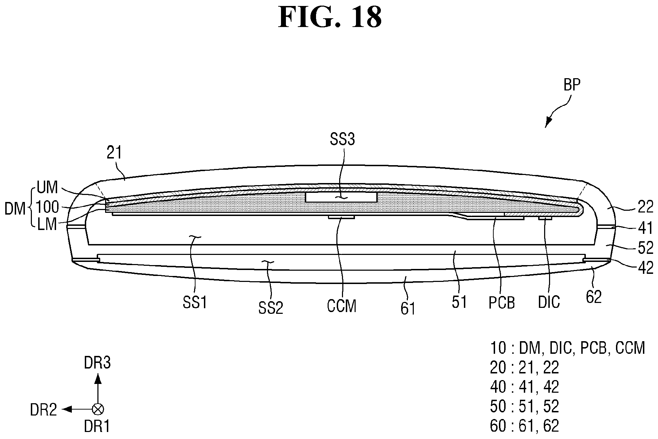

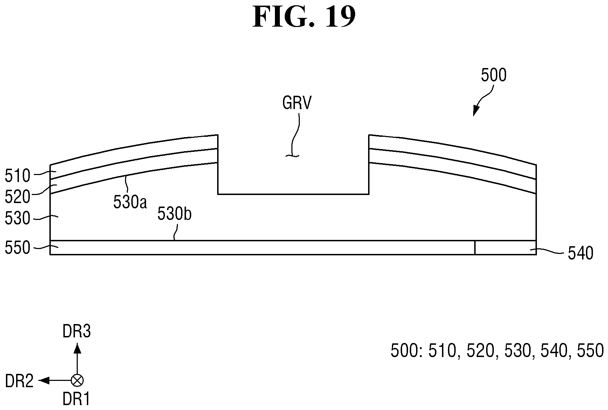

FIG. 18 is a cross-sectional view showing an example of a main body unit. FIG. 19 is a cross-sectional view showing an example of a cover panel.

Referring to FIGS. 18 and 19, the display device 1 illustrated differs from the display device 1 in the examples described above with reference to FIGS. 8, 13, and 16, in that it further includes a third storage space SS3 in the shape of a groove defined adjacent to the display panel 100.

More specifically, the third storage space SS3 may be a groove GRV defined by recessing at least a part of the top surface of the lower module LM. As shown in FIG. 19, the third storage space SS3 may be the groove GRV defined by recessing at least a part of the top surface of the cover panel 500 toward the bottom surface of the cover panel 500.

The groove GRV may penetrate the buffer layer 510, the bonding layer 520, and at least a part of the support layer 530. As shown in the drawing, the bottom surface of the groove GRV may be defined at a predetermined point inside the support layer 530 in the third direction DR3. However, the disclosure is not limited thereto, and the bottom surface of the groove GRV may be defined at any point inside the heat dissipation layer 550 or the cover spacer 540.

In concluding the detailed description, those skilled in the art will appreciate that many variations and modifications may be made to the preferred embodiments without substantially departing from the principles of the disclosure. Therefore, the disclosed preferred embodiments of the invention are used in a generic and descriptive sense only and not for purposes of limitation.

## Claims

1. A display device (1) comprising:
a cover window (20) comprising a first surface (20a) and a second surface (20b) opposite the first surface (20a);
a display panel (100) disposed on the second surface (20b) of the cover window (20); and
a cover panel (500) disposed on the display panel (100), and comprising:
a first surface (500a) facing the cover window (20); and
a second surface (500b) disposed opposite the first surface (500a),
wherein the second surface (20b) of the cover window and the first surface (500a) of the cover panel are curved, and the second surface (500b) of the cover panel is flat.

2. The display device of claim 1, wherein the display panel is curved along the second surface (20b) of the cover window (20).

3. The display device of claim 1, wherein a curvature of the second surface (20b) of the cover window (20) and a curvature of the first surface (500a) of the cover panel (500) are identical.

4. The display device of claim 3, wherein the radius of curvature of the second surface (20b) of the cover window (20) is 100 millimeters to 200 millimeters. [para [00137]]

5. The display device of claim 3 or 4, wherein the curvature of the first surface (20a) of the cover window (20) and a curvature of the second surface (20b) of the cover window (20) are identical.

6. The display device of claim 1, wherein the cover panel comprises:
a buffer layer (510) disposed on the display panel (100);
a bonding layer (520) disposed on the buffer layer (510); and
a support layer (530) disposed on the bonding layer (520), and comprising a first surface (530a) facing the cover window (20), and a second surface (530b) opposite the first surface (530a),
wherein the first surface (530a) of the support layer is curved, and the second surface (530b) of the support layer is flat. [Fig. 12]

7. The display device of claim 6, wherein the support layer includes at least one of polyethylene terephthalate, polyimide, polycarbonate, polyethylene, polypropylene, polysulfone, polymethylmethacrylate, triacetylcellulose or cycloolefin polymer.

8. The display device of claim 6 or 7, wherein the buffer layer (510) and the bonding layer (520) are curved along the shape of the first surface (530a) of the support layer (530).

9. The display device of claim 6, 7 or 8, wherein
the cover panel (500) further comprises at least one of a cover spacer (540) and a heat dissipation layer (550) disposed on the second surface (530b) of the support layer (530), and
the cover spacer (540) and the heat dissipation layer (550) are flat.

10. The display device of claim 9, wherein the heat dissipation layer (550) includes at least one of copper, silver, gold, aluminum, nickel, stainless steel, graphite, or carbon nanotubes.

11. The display device of any one of the preceding claims, wherein the outermost thickness of the cover panel is less than the central thickness of the cover panel.

12. The display device of any one of the preceding claims, further comprising a driving board (PCB) disposed on the second surface (500b) of the cover panel (500),
Wherein the driving board is flat along the second surface (500b) of the cover panel.

13. The display device of claim 12, further comprising a circuit component (CCM) disposed on the driving board,
wherein the circuit component is disposed on a flat surface of the driving board (PCB).
